# EUROPÄISCHE PATENTANMELDUNG

(11) **EP 4 654 478 A1**
(43) Veröffentlichungstag der Anmeldung: **26.11.2025**
(21) Anmeldenummer: 24177574.1
(22) Anmeldetag: 23.05.2024
(51) Int. Cl.: H03K 17/06, H02H 3/087, H03K 17/0814, H03K 17/082, H03K 17/10, H03K 17/12, H03K 17/687

(54) **EINRICHTUNG SOWIE VERFAHREN ZUR BEGRENZUNG EINES FEHLERSTROMES IN EINEM GLEICHSPANNUNGSNETZ**

(71) Anmelder: Siemens Energy Global GmbH & Co. KG, 81739 München (DE)
(72) Erfinder: Semmler, Sebastian, 90427 Nürnberg (DE); Alvarez Valenzuela, Rodrigo Alonso, 90409 Nürnberg (DE)

(57) **Zusammenfassung**

Die Erfindung betrifft eine Einrichtung (20) zum Begrenzen eines Fehlerstromes in einer Gleichspannungsverbindung (21-22) mit einer Reihenschaltung von Strombegrenzungsmodulen (23.1-23.2n), wobei jedes Strombegrenzungsmodul eine Mehrzahl von Leistungshalbleiterschaltern (331-33n) sowie einen Überspannungsableiter (34) in einer Parallelschaltung zu den Leistungshalbleitern umfasst. Die Erfindung zeichnet sich durch eine Steuerungseinrichtung (26, 37) zum Steuern der Leistungshalbleiterschalter aus, die dazu eingerichtet ist, die Leistungshalbleiterschalter mittels unterschiedlicher Gate-Emitter-Spannungen anzusteuern. Die Erfindung betrifft ferner ein Verfahren zum Begrenzen eines Fehlerstromes mittels der Einrichtung.

## Beschreibung

Die Erfindung betrifft eine Einrichtung zum Begrenzen eines Fehlerstromes in einer Gleichspannungsverbindung mit einer Reihenschaltung von Strombegrenzungsmodulen, wobei jedes Strombegrenzungsmodul eine Mehrzahl von Leistungshalbleiterschaltern sowie einen Überspannungsableiter in einer Parallelschaltung zu den Leistungshalbleitern umfasst.

Für den Betrieb von gleichspannungsbasierten Verteil- und Übertragungsnetzen (Punkt-zu-Punkt-, Multi-Terminal- und vermaschten Netzen) sind Einrichtungen zum Begrenzen bzw. Unterdrücken von Fehlerströmen (die oft als DC Circuit Breaker bzw. DC Fault Separation Devices bezeichnet werden) von Bedeutung. Im Gegensatz zu Wechselspannung/-strom existieren in Gleichspannungsnetzen keine natürlichen Stromnulldurchgänge, weshalb für diese Anwendung spezielle Lösungsansätze erforderlich sind. Für DC Circuit Breaker / DC Fault Separation Devices ist es von besonderer Bedeutung, dass diese geringe Durchlassverluste aufweisen. Zur Unterdrückung von Fehlerströmen können leistungselektronische Einrichtungen verwendet werden, bei denen neben der angesprochenen Minimierung von Durchlassverlusten auch die Vermeidung von De-ratings aufgrund der Parallel- und Reihenschaltung von Halbleitern eine technische Herausforderung darstellt.

Eine eingangs genannte Einrichtung ist aus der DE 10 2015 211 339 A1 bekannt. Die bekannte Einrichtung umfasst einen Leistungselektronischen Gleichstromleistungsschalter mit einer Reihenschaltung einer Mehrzahl von Halbleiterschaltelementen, die jeweils einen Leistungselektronischen Schalter und einen Überspannungsableiter aufweisen, sowie einem elektrisch parallel zu dieser Schalterreihenschaltung geschalteten Freilaufpfad. Die bekannte Lösung unterscheidet sich von Gleichspannungsschaltern, die mechanische Schalter im Betriebsstrompfad (derjenige Pfad, der im Normalbetrieb den Betriebsstrom führt) aufweisen, dadurch, dass bei dem bekannten Gleichstromleistungsschalter die Leistungshalbleiterschalter im Betriebsstrompfad angeordnet sind.

Die Aufgabe der vorliegenden Erfindung ist es, eine eingangs genannte Eirichtung bereitzustellen, die im Betrieb möglichst verlustarm und zuverlässig ist.

Die Aufgabe wird durch eine Einrichtung gemäß den Merkmalen des Patentanspruchs 1 gelöst.

Gemäß der Erfindung umfasst die Einrichtung eine Steuerungseinrichtung zum Steuern der Leistungshalbleiterschalter, die dazu eingerichtet ist, die Leistungshalbleiterschalter mittels unterschiedlicher Gate-Emitter-Spannungen anzusteuern. Die Steuerungseinrichtung ist demnach dazu eingerichtet, die Leistungshalbleiterschalter mittels Steuersignale einzuschalten bzw. zu sperren (sie ist dazu mit dem jeweiligen Gate des betreffenden Leistungshalbleiterschalters verbunden). Die Leistungshalbleiterschalter sind vorzugsweise abschaltbare Leistungshalbleiterschalter, wie beispielsweise IGBT, IGCT, MOSFET, JFET, SiC- oder GaN-basierte Leistungshalbleiterschalter.

Die Erfindung macht sich die Erkenntnis zunutze, dass die Kollektor-Emitter Spannung UCE (und damit auch die Durchlassverluste) an einem Leistungshalbleiter im Allgemeinen von der anliegenden Gate-Emitter-Spannung UGE abhängt (zumindest für Ströme bis zu ca. 2,5kA). Insbesondere sinkt im Allgemeinen die Spannung UCE, wenn die Spannung UGE angehoben wird. Ein Betrieb eines Halbleiterschalters mit erhöhter UGE ist beispielsweise in der WO 2012/107010 A1 beschrieben.

Gemäß der vorliegenden Erfindung werden jedoch nicht alle Leistungshalbleiterschalter mittels einer (und derselben) erhöhten Spannung UGE betrieben. Vielmehr werden die Leistungshalbleiterschalter kontrolliert mittels unterschiedlicher Gate-Emitter-Spannungen betrieben, um die Zuverlässigkeit der Einrichtung zu erhöhen.

Geeigneterweise liegt die Gate-Emitter-Spannung zwischen 18V bis 35V für die positive Spannung, bzw. 0 bis -15 V für die negative Spannung. Die Kollektor-Emitter Spannung UGE bei gesperrtem Leistungshalbleiterschalter kann von 1kV bis 10kV betragen. Die Durchlassspannung kann beispielsweise bis zu 10V betragen. Neben der Aktivierung bzw. Deaktivierung aller Strombegrenzungsmodule ist die Steuerungseinrichtung vorzugsweise dazu eingerichtet, nur einen Teil der Module anzusteuern, um bspw. Ströme zu sanft zu unterdrücken oder auf einen Maximalwert zu begrenzen.

Zweckmäßigerweise ist die Steuerungseinrichtung dazu eingerichtet, zumindest einen ersten Leistungshalbleiterschalter eines Strombegrenzungsmodul mittels einer ersten Gate-Emitter-Spannung anzusteuern, die einer nominalen Gate-Emitter-Spannung entspricht, und zumindest einen zweiten Leistungshalbleiterschalter desselben Strombegrenzungsmoduls mittels einer zweiten Gate-Emitter-Spannung anzusteuern, deren Betrag höher ist als die nominale Gate-Emitter-Spannung. Die Steuerungseinrichtung ist insbesondere dazu eingerichtet, zwei Leistungshalbleiterschalter eines und desselben Strombegrenzungsmoduls mittels unterschiedlicher Gate-Emitter-Spannungen anzusteuern. Beispielsweise kann ein erster Leistungshalbleiterschalter mittels einer ersten Gate-Emitter-Spannung angesteuert werden, die eine nominale Gate-Emitter-Spannung sein kann. Die nominale Gate-Emitter-Spannung wird beispielsweise vom Hersteller des betreffenden Leistungshalbleiters vorgegeben. Ein zweiter Leistungshalbleiterschalter kann mittels einer demgegenüber erhöhten Gate-Emitter-Spannung angesteuert werden.

Vorzugsweise umfasst zumindest ein Strombegrenzungsmodul mindestens zwei Leistungshalbleiterschalter, die in einer Reihenschaltung angeordnet sind. Insbesondere kann jedes Strombegrenzungsmodul jeweils zwei in Reihe geschaltete Leistungshalbleiterschalter umfassen. Die in Reihe geschalteten Leistungshalbleiterschalter werden derart mittels unterschiedlicher Gate-Emitter-Spannungen angesteuert (ein erster Leistungshalbleiterschalter der Reihenschaltung mittels einer ersten Gate-Emitter-Spannung, ein zweiter Leistungshalbleiterschalter der Reihenschaltung mittels einer zweiten, von der ersten verschiedenen, beispielsweise höheren, Gate-Emitter-Spannung), dass im Betrieb der Einrichtung an den Leistungshalbleiterschaltern jeweils eine gleiche Spannung abfällt, wodurch die Belastung der Leistungshalbleiter ausgeglichen ist und somit die Zuverlässigkeit der Einrichtung erhöht wird.

Auf diese Weise kann über die Gate-Emitter Spannung die Spanungsaufteilung beeinflusst werden (z.B. auf Basis einer aktiven Überspannungsbegrenzung durch Manipulation der Turnoff Spannung im Bereich von -15V bis hin zu leicht positiven Spannungen). Dies erlaubt vorteilhaft die Bereitstellung der Reihenschaltung ohne De-rating in der Spannungsausnutzung der Halbleiter.

Geeigneterweise umfasst zumindest ein Strombegrenzungsmodul mindestens zwei Leistungshalbleiterschalter, die antiseriell zueinander angeordnet sind. Insbesondere kann jedes Strombegrenzungsmodul jeweils (mindestens) zwei antiseriell geschaltete Leistungshalbleiterschalter umfassen. Mit einer antiseriellen Schaltung wird hierbei eine Anordnung der Leistungshalbleiterschalter verstanden, die in Reihe zueinander, jedoch miteinander entgegengesetzten Durchlassrichtungen bzw. Sperrrichtungen angeordnet sind. Auf diese Weise wird eine bidirektionale Abschaltfähigkeit der Einrichtung erreicht.

Gemäß einer Ausführungsform der Erfindung umfasst zumindest ein Strombegrenzungsmodul mindestens zwei Leistungshalbleiterschalter, die in einer Parallelschaltung zueinander angeordnet sind. Insbesondere kann jedes Strombegrenzungsmodul jeweils (mindestens) zwei parallelgeschaltete Leistungshalbleiterschalter umfassen. Grundsätzlich erhöht die Parallelschaltung die Stromtragfähigkeit der Einrichtung. Vorteilhaft ist es, dass durch (beispielsweise geringfügige) Anpassung der Gate-Emitter-Spannung, Asymmetrien im mechanischen Aufbau (parasitäre Widerstände und Induktivitäten) kompensiert werden können. Insbesondere werden die parallelgeschalteten Leistungshalbleiterschalter derart mittels unterschiedlicher Gate-Emitter-Spannungen angesteuert (ein erster Leistungshalbleiterschalter der Parallelschaltung mittels einer ersten Gate-Emitter-Spannung, ein zweiter Leistungshalbleiterschalter der Parallelschaltung mittels einer zweiten, von der ersten verschiedenen Gate-Emitter-Spannung), dass ein gleicher Strom durch die parallelgeschalteten Leistungshalbleiter fließt, wodurch die Belastung der Leistungshalbleiter ausgeglichen ist und somit die Zuverlässigkeit der Einrichtung weiter erhöht wird.

Gemäß einer besonders bevorzugten Ausführungsform der Erfindung umfasst zumindest ein Strombegrenzungsmodul mindestens vier Leistungshalbleiterschalter umfasst, die in einer Parallelschaltung von je zwei antiseriell zueinander angeordneten Leistungshalbleiterschaltern angeordnet sind. Gemäß dieser Ausführungsform können die zuvor beschriebenen Vorteile der antiseriellen und parallelen Schaltung von Leistungshalbleiterschaltern kombiniert werden. Das Strombegrenzungsmodul kann selbstredend mehr als zwei parallel angeordnete Leistungshalbleiter umfassen. Auch ist eine Reihenschaltung von mehreren Leistungshalbleiterschaltern denkbar. Es kann von Vorteil sein, wenn einige oder gar alle Strombegrenzungsmodule einen solchen Aufbau mit seriellen, antiseriellen und/oder parallelen Leistungshalbleiterschaltern aufweisen. Zweckmäßigerweise ist eine mehrfache Parallelschaltung möglich, um Skalierbarkeit bzgl. Nennstrom und max. zulässigem Fehlerstrom zu ermöglichen.

Bevorzugt umfasst zumindest ein Strombegrenzungsmodul, besonders bevorzugt alle Strombegrenzungsmodule, einen Überbrückungsschalter zum Überbrücken des Strombegrenzungsmoduls in einem Fehlerfall. Der Überbrückungsschalter ist bevorzugt ein schnelles (typischerweise mechanisches) Schließelement, das parallel zu den Leistungshalbleiterschaltern des Strombegrenzungsmoduls geschaltet ist. Mittels des bzw. der Überbrückungsschalter können einzelne fehlerhafte Strombegrenzungsmodule überbrückt werden zu können. Dadurch kann ein zuverlässiger Betrieb der gesamten Einrichtung gewährleistet werden.

Geeigneterweise umfasst zumindest ein Strombegrenzungsmodul einen Parallelwiderstand in einer Parallelschaltung zum Überspannungsableiter. Es kann von Vorteil sein, wenn alle Strombegrenzungsmodule jeweils einen solchen Parallelwiderstand umfassen. Der Strombegrenzungsmodul-interne Parallelwiderstand sorgt für eine symmetrische Spannungsaufteilung innerhalb der gesamten Einrichtung, wenn diese deaktiviert (=ausgeschaltet) ist.

Die Einrichtung kann ferner eine Stromversorgungsvorrichtung zum Versorgen der Strombegrenzungsmodule mit Energie umfassen, die von den Strombegrenzungsmodulen galvanisch getrennt ist. Die Stromversorgungsvorrichtung kann beispielsweise eine zentrale Hilfsenergieversorgung (Device Power Supply), die die Strombegrenzungsmodule galvanisch getrennt (z.B. per Laserübertragung) mit Energie versorgt

Die Leistungshalbleiterschalter sind geeigneterweise mittels einer aktiven Kühlung entwärmbar. Dies kann beispielsweise mittels einer Wasserkühlung realisiert werden.

Die Einrichtung umfasst bevorzugt eine Reihenschaltung von mehr als zwei Strombegrenzungsmodulen. Die Leistungshalbleiterschalter können wahlweise mit oder ohne integrierte (antiparallele) Diode (dann als separates Element) sein. Die Leistungshalbleiterschalter können ferner wahlweise normallyoff oder normally-on Charakteristik besitzen (auch als Verarmungs- bzw. Anreicherungstyp des Halbleiters bezeichnet). Eine Anpassung an das gewünschte Systemverhalten (Safe-stateoff) erfolgt über eine Strombegrenzungsmodul-interne Steuereinheit (Module Control Unit). Die Module Control Unit ist generell für die Ansteuerung der Leistungshalbleiter, die Überwachung des Modulzustandes und die Kommunikation zur überlagerten Regelung bzw. Steuerung eingerichtet. Sie wird durch eine Modulversorgung (Module Power Supply) mit Hilfsenergie versorgt. Der antiseriellen Verschaltung der Leistungshalbleiter im Strombegrenzungsmodul ist der Überspannungsableiter parallelgeschaltet, in den der Gleichstrom hinein kommutiert, sobald die Leistungshalbleiterschalter geöffnet (gesperrt) werden. Der durch das Strombegrenzungsmodul fließende Gleichstrom wird auf diese Weise hochimpedant unterdrückt (Energieaufnahme) und auf einen geringen Reststrom (z.B. <10A) abgesenkt.

Innerhalb der Einrichtung wird eine variable Anzahl n an Strombegrenzungsmodulen in Reihe geschaltet (n>2), um eine Anpassung an verschiedene Nennspannungen und Redundanz zu ermöglichen. Die Einrichtung umfasst des Weiteren die Steuerungseinrichtung (Device Control Unit), welche die Strombegrenzungsmodule ansteuert (inkl. der Gate-Treiber mit kontrollierbar erhöhter Gate-Emitter Spannung) und deren Zustand überwacht. Neben der Aktivierung bzw. Deaktivierung aller Strombegrenzungsmodule ist die Device Control Unit in der Lage, nur einen Teil der Strombegrenzungsmodule anzusteuern, um bspw. Ströme zu sanft zu unterdrücken oder auf einen Maximalwert zu begrenzen.

Die Erfindung ist vorteilhaft in einem Gleichspannungsnetz mit einer Mehrzahl von Stromrichtern verwendbar, die mittels Gleichspannungsverbindungen miteinander verbunden sind, wobei mittels wenigstens einer erfindungsgemäßen Einrichtung ein Fehlerstrom in einer der Gleichspannungsverbindungen begrenzt werden kann. Die Einrichtung bzw. die Einrichtungen können dazu eingesetzt werden, in einem Fehlerfall im Gleichspannungsnetz den Fehlerort zu isolieren, den Fehler zu klären, und einen Weiterbetrieb des vom Fehler nicht betroffenen Teils des Gleichspannungsnetzes zu ermöglichen.

Die Erfindung betrifft ferner ein Verfahren zum Begrenzen eines Fehlerstromes in einer Gleichspannungsverbindung mittels einer Einrichtung umfassend eine Reihenschaltung von Strombegrenzungsmodulen, wobei jedes Strombegrenzungsmodul eine Mehrzahl von Leistungshalbleiterschaltern sowie einen Überspannungsableiter in einer Parallelschaltung zu den Leistungshalbleitern umfasst, sowie eine Steuerungseinrichtung zum Steuern der Leistungshalbleiterschalter. Bei dem erfindungsgemäßen Verfahren werden die Leistungshalbleiterschalter mittels unterschiedlicher Gate-Emitter-Spannungen angesteuert werden.

Die Vorteile des erfindungsgemäßen Verfahrens entsprechen insbesondere denjenigen, die bereits im Zusammenhang mit der erfindungsgemäßen Einrichtung beschrieben wurden.

Die Erfindung wird nachfolgend anhand von in den Figuren 1 bis 3 dargestellten Ausführungsbeispielen weiter erläutert.
Figur 1 zeigt ein Ausführungsbeispiel eines erfindungsgemäßen Gleichspannungsnetzes in einer schematischen Darstellung;
Figur 2 zeigt ein Ausführungsbeispiel einer erfindungsgemäßen Einrichtung zum Begrenzen eines Fehlerstromes in einer schematischen Darstellung;
Figur 3 zeigt ein Beispiel eines Strombegrenzungsmoduls in einer schematischen Darstellung.

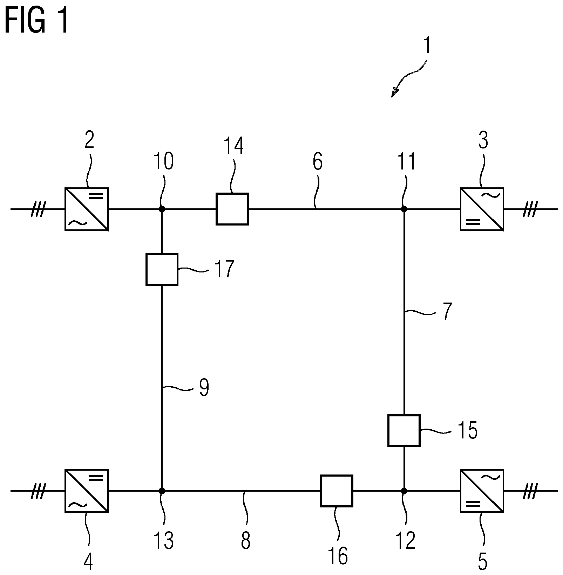

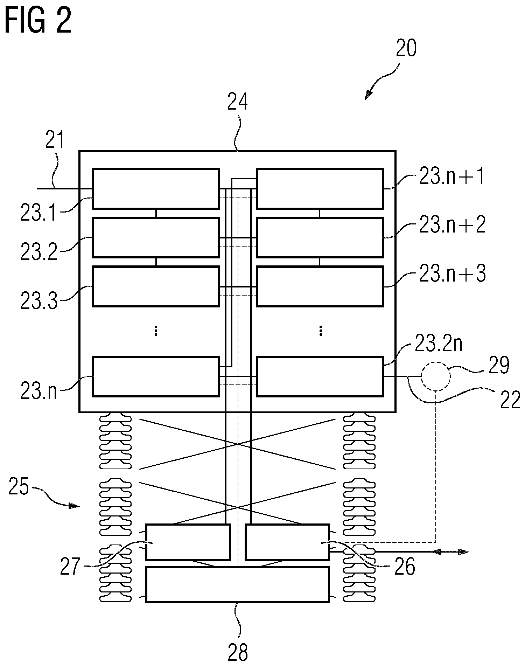

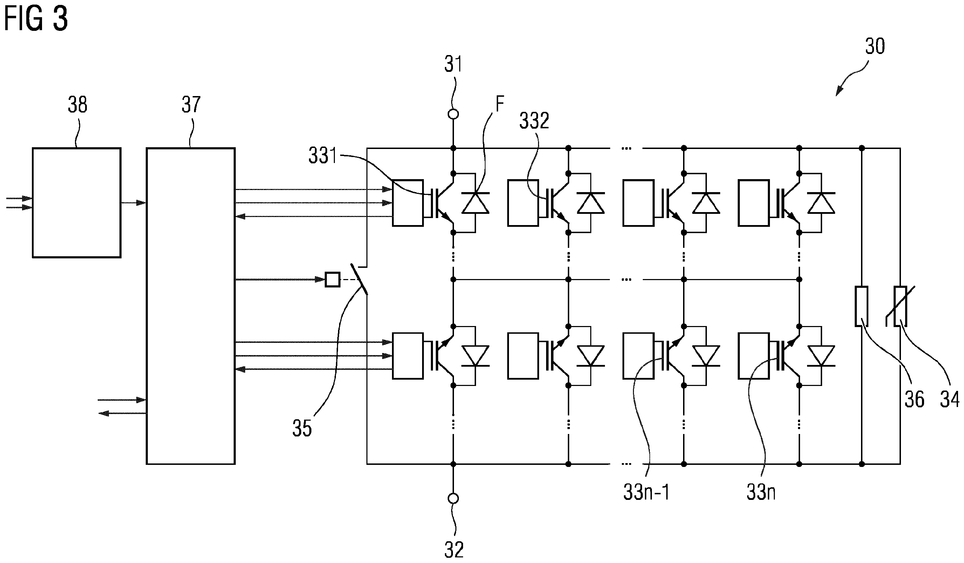

In Figur 1 ist ein Gleichspannungsnetz 1 dargestellt. Das Gleichspannungsnetz 1 umfasst vier Stromrichter 2-5, die jeweils zwischen einem Wechselspannungsnetz und dem Gleichspannungsnetz 1 angeordnet sind. Die Stromrichter 2-5 sind mittels Gleichspannungsverbindungen 6-9 miteinander verbunden. Die Gleichspannungsverbindungen 6-9 können Monopol- oder bsp. auch Bipol-Verbindungen sein. Die Gleichspannungsverbindungen 6-9 sind an Gleichspannungsknoten 10-13 aneinandergekoppelt. In räumlicher Nähe von zwei Gleichspannungsknoten 10 und 12 sind eine erste, eine zweite, eine dritte und eine vierte Einrichtung 14-17 angeordnet, mittels deren ein Fehlerstrom in der zugeordneten Gleichspannungsverbindung 6-9 begrenzt werden kann. Auf den Aufbau der Einrichtungen wird in den nachfolgenden Figuren 2 und 3 näher eingegangen.

In Figur 2 ist eine Einrichtung 20 zum Begrenzen eines Fehlerstromes in einer Gleichspannungsverbindung (auch als fault separation device bezeichnet) dargestellt, beispielsweise einer der Gleichspannungsverbindungen 6-9 der Figur 1. Die Einrichtung 20 umfasst einen ersten Anschluss 21, einen zweiten Anschluss 22 sowie eine Reihenschaltung von Strombegrenzungsmodulen 23.1 bis 23.2n. Auf den Aufbau der Strombegrenzungsmodulen 23.1-23.2n wird nachfolgend in Figur 3 näher eingegangen.

Die Strombegrenzungsmodule 23.1-23.2n sind in einer Aufnahmeeinrichtung 24 angeordnet, die mittels Isolatoren 25 vom Erdpotenzial isoliert ist. Die Einrichtung 20 umfasst ferner eine Steuerungseinrichtung 26 zum Steuern der Strombegrenzungsmodule 23.1-23.2n bzw. deren Leistungshalbleiterschalter, eine Stromversorgungsvorrichtung 27 zur Energieversorgung der Strombegrenzungsmodule 23.1-23.2n, eine Kühleinrichtung 28 zum Kühlen der Strombegrenzungsmodule 23.1-23.2n bzw. deren Leistungshalbleiter sowie eine Messvorrichtung 29 zum Erfassen von Messgrößen wie Strom und/oder Spannung an der Einrichtung 20.

In Figur 3 ist ein Strombegrenzungsmodul 30 dargestellt, das beispielsweise eines der Strombegrenzungsmodule 23.1-23.2n sein kann. Das Strombegrenzungsmodul 30 weist einen ersten Modulanschluss 31 und einen zweiten Modulanschluss 32 auf. Das Strombegrenzungsmodul 20 umfasst Leistungshalbleiterschalter 331-33n. die zueinander antiseriell und parallelgeschaltet sind. Jedem Leistungshalbleiterschalter 331-33n ist eine Freilaufdiode F antiparallel geschaltet.

Den Leistungshalbleitern 331-33n im Strombegrenzungsmodul 30 ist ein Überspannungsableiter 34 parallelgeschaltet, in den der Gleichstrom (Fehlerstrom) hinein kommutiert, sobald die Leistungshalbleiterschalter geöffnet (gesperrt) werden. Der durch das Strombegrenzungsmodul 30 fließende Gleichstrom wird auf diese Weise hochimpedant unterdrückt (Energieaufnahme) und auf einen geringen Reststrom (z.B. <10A) abgesenkt.

Die Anzahl der Strombegrenzungsmodule in einer erfindungsgemäßen Einrichtung ist derart bemessen, dass auch bei Ausfall einiger Strombegrenzungsmodule die gesamte Einrichtung im Betrieb bleiben kann und ihre Funktion erfüllen kann (Redundanz). Entsprechend ist parallel zu den Leistungshalbleiterschaltern 331-33n des Strombegrenzungsmoduls 30 ein schnelles, mechanisches Schließelement bzw. Überbrückungsschalter 35 parallelgeschaltet, um einzelne fehlerhafte Strombegrenzungsmodule überbrücken zu können und dadurch einen zuverlässigen Betrieb der gesamten Einrichtung zu gewährleisten.

Mittels eines Parallelwiderstandes 36 wird eine gleichmäßige (symmetrische) Spannungsaufteilung innerhalb des Strombegrenzungsmoduls 30 bei gesperrten Leistungshalbleiterschaltern 331-33n erreicht.

Das Strombegrenzungsmodul 30 umfasst ferner eine Modul-Steuerungseinrichtung 37, die mit den Gates der Leistungshalbleiterschalter 331-33n sowie mit einem zentralen Teil der Steuerungseinrichtung (Nr. 26 in Figur 2) verbunden ist. Der zentrale Teil der Steuerungseinrichtung bildet zusammen mit allen Modul-Steuerungseinrichtungen die Steuerungseinrichtung zum Ansteuern der Leistungshalbleiterschalter aus. Die Modul-Steuerungseinrichtung 37 umfasst insbesondere die entsprechenden Gate-Treiber mit kontrollierbar erhöhter Gate-Emitter Spannung. Die Modul-Steuerungseinrichtung 37 ist zur Ansteuerung der Leistungshalbleiter, zur Überwachung des Modulzustandes und zur Kommunikation mit überlagerten Steuerungseinrichtungen ausgebildet.

Ein Modul-Energieversorgungsmodul 38 ist zum Energieversorgen der Modul-Steuerungseinrichtung vorgesehen und dazu galvanisch getrennt (bsp. mittels Lichtwellenleiter) mit einer zentralen Stromversorgungsvorrichtung verbunden.

Im Betrieb wird der erste Leistungshalbleiterschalter 331 mittels einer nominalen Gate-Emitter-Spannung angesteuert (bsp. gemäß Datenblatt bzw. der entsprechenden Spezifikation des Herstellers). Der zweite Leistungshalbleiterschalter 332 wird hingegen mittels einer gegenüber der nominalen Gate-Emitter-Spannung erhöhten Gate-Emitter-Spannung angesteuert. Die Festlegung der verwendeten Gate-Emitter-Spannungen kann einmalig bei Inbetriebnahme oder dynamisch, wiederholt und im Betrieb festgelegt werden.

## Patentansprüche

1. Einrichtung (20) zum Begrenzen eines Fehlerstromes in einer Gleichspannungsverbindung umfassend eine Reihenschaltung von Strombegrenzungsmodulen (23.1-23.2n), wobei jedes Strombegrenzungsmodul (23) eine Mehrzahl von Leistungshalbleiterschaltern (331-33n) sowie einen Überspannungsableiter (34) in einer Parallelschaltung zu den Leistungshalbleitern (331-33n) umfasst,
**gekennzeichnet durch**
eine Steuerungseinrichtung (26) zum Steuern der Leistungshalbleiterschalter (331-33n), die dazu eingerichtet ist, die Leistungshalbleiterschalter (331-33n) mittels unterschiedlicher Gate-Emitter-Spannungen anzusteuern.

2. Einrichtung (20) nach Anspruch 1, wobei die Steuerungseinrichtung (26) dazu eingerichtet ist, zumindest einen ersten Leistungshalbleiterschalter (331-33n) eines Strombegrenzungsmoduls (23.1-23.2n) mittels einer ersten Gate-Emitter-Spannung anzusteuern, die einer nominalen Gate-Emitter-Spannung entspricht, und zumindest einen zweiten Leistungshalbleiterschalter (331-33n) desselben Strombegrenzungsmoduls (23.1-23.2n) mittels einer zweiten Gate-Emitter-Spannung anzusteuern, deren Betrag höher ist als die nominale Gate-Emitter-Spannung.

3. Einrichtung (20) nach einem der vorangehenden Ansprüche, wobei zumindest ein Strombegrenzungsmodul (23.1-23.2n) mindestens zwei Leistungshalbleiterschalter (331-33n) umfasst, die in einer Reihenschaltung angeordnet sind.

4. Einrichtung (20) nach einem der vorangehenden Ansprüche, wobei zumindest ein Strombegrenzungsmodul (23.1-23.2n) mindestens zwei Leistungshalbleiterschalter (331-33n) umfasst, die antiseriell zueinander angeordnet sind.

5. Einrichtung (20) nach einem der vorangehenden Ansprüche, wobei zumindest ein Strombegrenzungsmodul (23.1-23.2n) mindestens zwei Leistungshalbleiterschalter (331-33n) umfasst, die in einer Parallelschaltung zueinander angeordnet sind.

6. Einrichtung (20) nach einem der vorangehenden Ansprüche, wobei zumindest ein Strombegrenzungsmodul (23.1-23.2n) mindestens vier Leistungshalbleiterschalter (331-33n) umfasst, die in einer Parallelschaltung von je zwei antiseriell zueinander angeordneten Leistungshalbleiterschaltern (331-33n) angeordnet sind.

7. Einrichtung (20) nach einem der vorangehenden Ansprüche, wobei zumindest ein Strombegrenzungsmodul (23.1-23.2n) einen Überbrückungsschalter (35) zum Überbrücken des Strombegrenzungsmoduls (23.1-23.2n) in einem Fehlerfall umfasst.

8. Einrichtung (20) nach einem der vorangehenden Ansprüche, wobei zumindest ein Strombegrenzungsmodul (23.1-23.2n) einen Parallelwiderstand (36) in einer Parallelschaltung zum Überspannungsableiter umfasst.

9. Einrichtung (20) nach einem der vorangehenden Ansprüche, wobei die Einrichtung eine Stromversorgungsvorrichtung (27) zum Versorgen der Strombegrenzungsmodule (23.1-23.2n) mit Energie umfasst, die von den Strombegrenzungsmodulen (23.1-23.2n) galvanisch getrennt ist.

10. Einrichtung (20) nach einem der vorangehenden Ansprüche, wobei die Leistungshalbleiterschalter (331-33n) mittels einer aktiven Kühlung entwärmbar sind.

11. Gleichspannungsnetz (1) mit einer Mehrzahl von Stromrichtern (2-5), die mittels Gleichspannungsverbindungen (6-9) miteinander verbunden sind, und mit wenigstens einer Einrichtung (14-17) nach einem der vorangehenden Ansprüche, mittels der ein Fehlerstrom in einer der Gleichspannungsverbindungen (6-9) begrenzt werden kann.

12. Verfahren zum Begrenzen eines Fehlerstromes in einer Gleichspannungsverbindung (6-9) mittels einer Einrichtung umfassend
- eine Reihenschaltung von Strombegrenzungsmodulen (23.1-23.2n), wobei jedes Strombegrenzungsmodul (23.1-23.2n) eine Mehrzahl von Leistungshalbleiterschaltern (331-33n) sowie einen Überspannungsableiter (36) in einer Parallelschaltung zu den Leistungshalbleitern (331-33n) umfasst, sowie
- eine Steuerungseinrichtung (26, 37) zum Steuern der Leistungshalbleiterschalter (331-33n),
bei dem die Leistungshalbleiterschalter (331-33n) mittels unterschiedlicher Gate-Emitter-Spannungen angesteuert werden.
